Europäisches Patentamt

(19) ⟩) **European Patent Office**

Office européen des brevets

(11) Veröffentlichungsnummer: **0 214 414**
**B1**

(12) **EUROPÄISCHE PATENTSCHRIFT**

(45) Veröffentlichungstag der Patentschrift:
**14.11.90**

(21) Anmeldenummer: **86109861.4**

(22) Anmeldetag: **17.07.86**

(51) Int. Cl.⁵: **H01L 23/48**

(54) **Verfahren zum Herstellen eines beidseitig kontaktierten Halbleiterkörpers.**

(30) Priorität: **31.08.85 DE 3531209**

(43) Veröffentlichungstag der Anmeldung:
**18.03.87 Patentblatt 87/12**

(45) Bekanntmachung des Hinweises auf die Patenterteilung:
**14.11.90 Patentblatt 90/46**

(84) Benannte Vertragsstaaten:
**DE FR GB NL**

(56) Entgegenhaltungen:
**EP-A- 0 109 887**
**GB-A- 2 067 354**
**US-A- 4 143 383**
**US-A- 4 189 342**

**MICROWAVE JOURNAL, Band 25, Nr. 3, März 1982,**
**Seiten 81-85, Dedham, Mass., US; D.D. KHANDELWAL:**
**"Beam lead IMPATTs - A new dimension"**

(73) Patentinhaber: **Licentia Patent-Verwaltungs-GmbH,**
**Theodor-Stern-Kai 1, D-6000 Frankfurt/Main 70(DE)**

(72) Erfinder: **Behr, Wolfgang, Dipl.-Phys., Gänsackerweg 9,**
**D-7915 Thalfingen(DE)**
Erfinder: **Müssigmann, Artur, Georg-Zoller-Strasse 22,**
**D-7930 Ehingen(DE)**
Erfinder: **Schaub, Anton, Täfingerweg 11,**
**D 7918 Illertissen(DE)**

(74) Vertreter: **Schulze, Harald Rudolf, Dipl.-Ing. et al,**
**Licentia Patent-Verwaltungs-GmbH**
**Theodor-Stern-Kai 1, D-6000 Frankfurt/Main 70(DE)**

## Beschreibung

Die Erfindung betrifft ein Verfahren zum Herstellen eines beidseitig kontaktierten Halbleiterkörpers nach dem Oberbegriff des Patentanspruchs 1.

Die Erfindung ist insbesondere für Halbleiterbauelemente anwendbar, die als Impattdiode ausgebildet sind. Derartige Halbleiterbauelemente werden in der Elektrotechnik insbesondere für den GHz-Bereich eingesetzt.

Bei der Herstellung derartiger Halbleiterbauelemente ist es erforderlich, an den eigentlichen Halbleiterkörper einen metallischen Kontaktdraht oder vorzugsweise ein Kontaktband, z.B. aus Gold, anzubringen als Stromzuleitung.

Halbleiterkörper und Kontaktband sind in einem Gehäuse untergebracht, das als Schutz und gleichzeitig als Kühlkörper dient. Die Verbindung zwischen dem Halbleiterkörper und dem Kontaktband erfolgt mit Hilfe einer derzeit üblichen Technologie, z.B. Binden oder Kleben mit einem elektrisch leitfähigen Kleber.

Ein derartiges Verfahren hat insbesondere bei einer industriellen Massenfertigung den Nachteil, daß keine reproduzierbaren parasitären Kapazitäten und Induktivitäten vorhanden sind. Es ist daher in unwirtschaftlicher Weise erforderlich, die bereits in ein Gehäuse eingebauten und kontaktierten Halbleiterbauelemente durch Meßverfahren zu klassifizieren.

Aus Microwave Journal, March 1982, p. 81–86 ist ein Verfahren zur Herstellung einer Impatt-Diode mit Abscheidung von den Halbleiterkörper der Diode kontaktierenden Metallbändern als Zuleitungen bekannt. Aus einer auf einem Trägerkörper befestigten Halbleiterschicht wird dabei die Diode als Mesa-Struktur herausgeätzt. Photolithographisch werden Strukturen für die Kontaktbänder erzeugt und diese Kontaktbänder mittels Kathodenzerstäubung und Plattieren hergestellt.

Ein Verfahren gemäß dem Oberbegriff von Anspruch 1 ist aus US-A 4 189 342 bekannt.

Der Erfindung liegt die Aufgabe zugrunde, ein kostengünstiges gattungsgemäßes Verfahren anzugeben, das insbesondere bei einer industriellen Massenfertigung eine reproduzierbare und zuverlässige Kontaktierung von Halbleiterkörpern ermöglicht.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß ein kostengünstiger maschineller Einbau des kontaktierten Halbleiterkörpers in ein Gehäuse möglich ist. Dabei werden bei verschiedenen Halbleiterbauelementen im wesentlichen gleiche parasitäre Kapazitäten und Induktivitäten erreicht.

Die Erfindung wird im folgenden an einem Ausführungsbeispiel näher erläutert unter Bezugnahme auf eine schematische Zeichnung. Die

FIG. 1 bis 9 zeigen einzelne Verfahrensschritte zur Erläuterung der Erfindung

FIG. 10 zeigt einen monolithisch integrierten Schaltkreis mit einer Impattdiode.

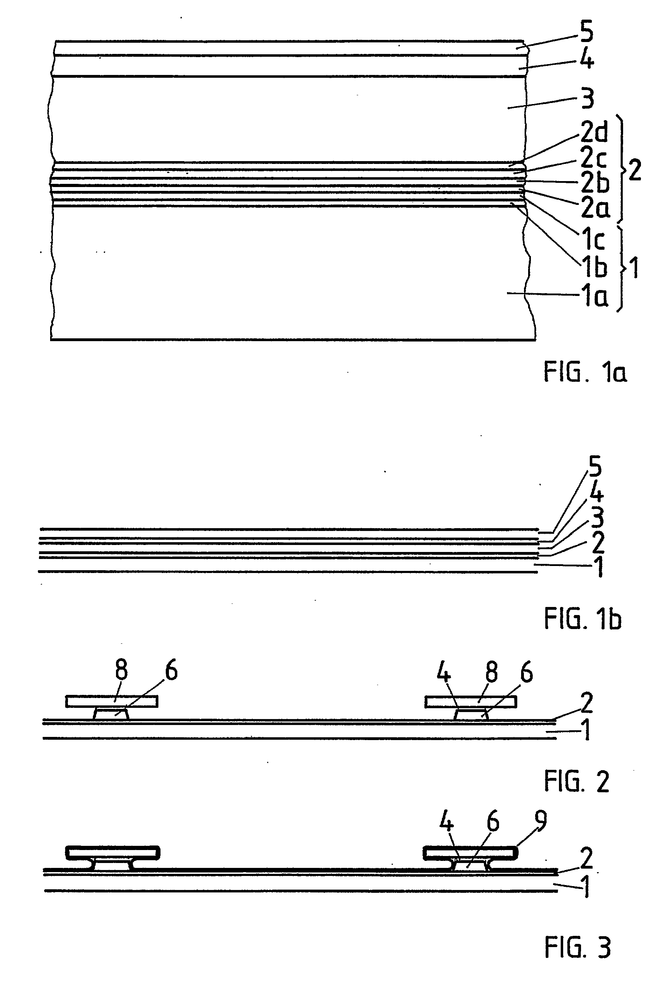

Gemäß Fig. 1a ist auf einem plattenförmigen Trägerkörper 1a, der z.B. aus Saphir oder Glas besteht und eine Dicke von ungefähr 0,4 mm besitzt, eine etwa 20 mm dicke Haftvermittlerschicht 1b aus Chrom und eine etwa 1 µm dicke Goldschicht 1c aufgebracht. An diese Zwischenschicht 1b, 1c schließt sich der beidseitig metallisierte Halbleiterkörper an, wobei

– die untere Metallisierungsschicht 2 aus einer ungefähr 1 µm dicken Goldschicht 2a, einer ungefähr 0,3 µm dicken Silberschicht 2b und einer etwa 0,5 µm dicken Goldschicht 2c mit einer darauf angebrachten Haftvermittlerschicht 2d aus Titan besteht,

– die Halbleiterschicht 3, die bei einer herzustellenden Impattdiode eine Dicke von ungefähr 2–5 µm besitzt und z.B. aus entsprechend dotierten Silizium-Halbleiterschichten besteht, epitaktisch aufgewachsen wird

– die obere Metallisierungsschicht 4, die eine Dicke von ungefähr 0,2 µm besitzt, aus einer Haftvermittlerschicht aus Titan sowie einer darauf abgeschiedenen Goldschicht besteht und

– eine darauf abgeschiedene Metallschutzschicht 5, die eine Dicke von ungefähr 0,2 µm besitzt, aus Chrom besteht.

Über die Goldschichten 1c, 2a werden Trägerkörper und beidseitig metallisierter Halbleiterkörper miteinander kalt verschweißt.

Die Silberschicht 2b dient als Trennschicht, um in einem späteren Arbeitsgang den Halbleiterkörper vom Trägerkörper zu entfernen.

Die Fig. 1b zeigt eine vereinfachte Darstellung von Trägerkörper inklusive Zwischenschicht 1, der unteren Metallisierungsschicht 2, der Halbleiterschicht 3, der oberen Metallisierungsschicht 4 und der Metallschutzschicht 5.

Auf die Metallschutzschicht 5 werden nun eine nicht dargestellte Fotolackschicht aufgeschleudert und kreisförmige Flächen belichtet und entwickelt, die einen Durchmesser von ungefähr 150 µm besitzen und in einem Raster mit einem Abstand von ungefähr 1 mm angeordnet sind. Nach mehreren Ätzvorgängen entsteht eine Anordnung gemäß Fig. 2. Von der Metallschutzschicht 5 sind lediglich die kreisförmigen weiteren Bereiche 8 vorhanden, welche den bereits erwähnten Durchmesser von ungefähr 150 µm besitzen. Aus der Halbleiterschicht 3 ist durch eine Unterätzung der weiteren Bereiche 8 ein kreiszylinderförmiger Halbleiterkörper 6 entstanden, der z.B. einen Durchmesser von ungefähr 35 µm besitzt.

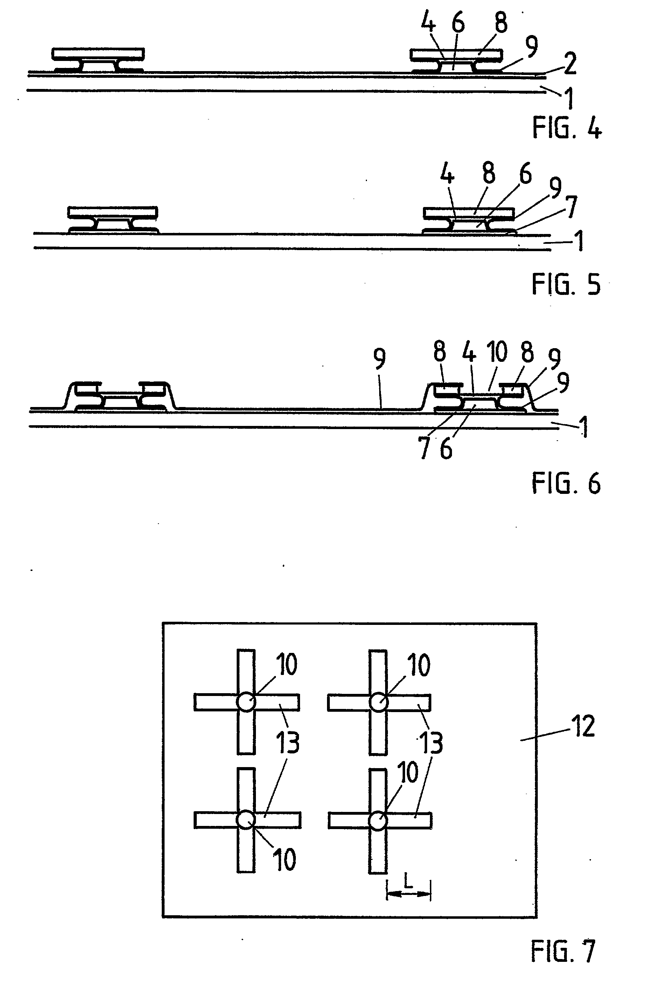

Anschließend wird gemäß Fig. 3 erneut Fotolack 9 derart aufgeschleudert, daß die entstandene pilzförmige Struktur vollständig umschlossen ist. Nach einer ganzflächigen Belichtung und Entwicklung ist lediglich unterhalb des weiteren Bereichs 8 schützender Fotolack vorhanden (Fig. 4), so daß bei einer nachfolgenden Ätzung die untere Metallisierungsschicht 2 bis auf den an den Halbleiterkörper 6 angrenzenden Bereich 7 entfernt wird (Fig. 5). Anschließend wird erneut Fotolack 9 aufgeschleudert und so belichtet und entwickelt, daß in dem weiteren Bereich 8 durch einen weiteren Ätzschritt in der Metallschutzschicht ein bis auf die obere Metallisierungsschicht 4 reichendes kreisförmiges Kontaktfenster 10 entsteht, dessen Durchmesser im wesentlichen demjenigen des Halbleiterkörpers 6 entspricht (Fig. 6).

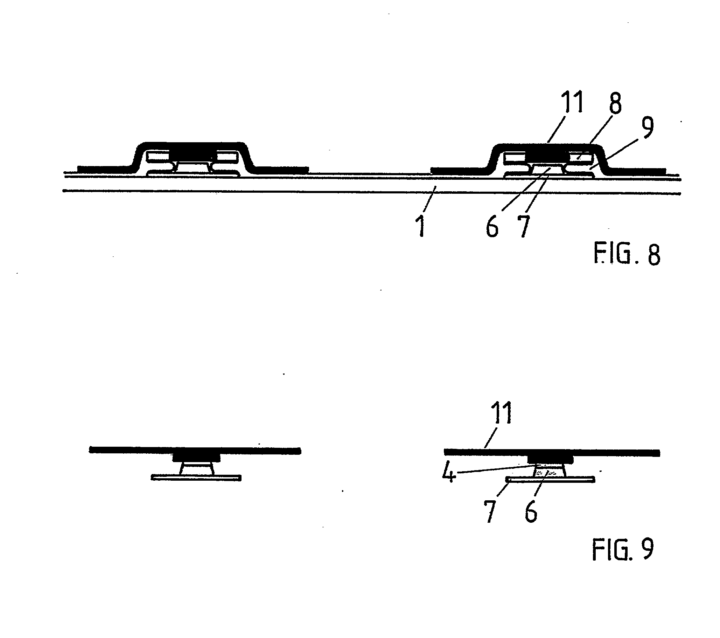

Gemäß Fig. 7 wird nun eine Aufdampfmaske 12, die kreuzförmige Schlitze 13 mit einer Länge L von ungefähr 0,8 mm und einer Breite von ungefähr 40 µm enthält über dem Kontaktfenster 10 justiert und eine Goldschicht aufgedampft, die als Startschicht dient für eine nachfolgende galvanische Gold-Verstärkung. Es entstehen die gewünschten Kontaktbänder 11 (Fig. 8).

Nach dem Entfernen des Fotolacks 9, des daran anhaftenden weiteren Bereichs 8 sowie des Trägerkörpers 1 entsteht ein beidseitig kontaktiertes Halbleiterbauelement (Fig. 9), z.B. eine Impattdiode.

Der Trägerkörper 1 wird durch Wegätzen der Trennschicht 2b vom Halbleiterkörper 6 entfernt.

Das beidseitig kontaktierbare Halbleiterbauelement, z.B. eine Impattdiode läßt sich in kostengünstiger und reproduzierbarer Weise in eine Wärmesenke mit Hilfe der Bondtechnik einbauen. Die Wärmesenke enthält einen Kupferstift, in dem ein vergoldeter Diamant eingepaßt ist.

Die Erfindung ist nicht auf das beschriebene Ausführungsbeispiel beschränkt, sondern sinngemäß auf weitere anwendbar, beispielsweise auf die Kontaktierung von Halbleiter-Laserdioden.

**Patentansprüche**

1. Verfahren zum Herstellen eines beidseitig kontaktierten Halbleiterkörpers aus einer auf einem Trägerkörper (1) angeordneten Halbleiterschicht (3) mit einer einem Halbleiterbauelement entsprechenden Schichtenfolge,
— wobei die Halbleiterschicht (3) durch eine obere Metallisierungsschicht (4) und eine untere Metallisierungsschicht (2) begrenzt wird
— wobei auf der oberen Metallisierungsschicht (4) eine Metallschutzschicht (5) abgeschieden wird
— wobei ein weiterer Bereich (8) in der Metallschutzschicht (5) gebildet wird, dadurch gekennzeichnet
— daß durch Unterätzen des weiteren Bereichs (8) ein Halbleiterkörper (6) aus der Halbleiterschicht (3) erzeugt wird
— daß photolithographisch unter Benutzung des weiteren Bereichs (8) als Maske die untere Metallisierungsschicht (2) bis auf einen Bereich (7) entfernt wird.
— daß in dem weiteren Bereich (8) ein Kontaktfenster (10) erzeugt wird, dessen Fläche im wesentlichen der des Halbleiterkörpers (6) entspricht
— daß mindestens ein Kontaktband (11) abgeschieden wird, das über das Kontaktfenster (10) mit dem Halbleiterkörper (6) verbunden ist, und
— daß anschließend der Trägerkörper (1) entfernt wird.

2. Verfahren nach Anspruch 1, dadurch gekennzeichnet, daß die untere Metallisierungsschicht (2) eine Trennschicht (2b) enthält und daß zum Entfernen des Trägerkörpers die Trennschicht (2b) weggeätzt wird.

3. Verfahren zur Herstellung eines beidseitig kontaktierten Halbleiterkörpers nach einem der vorhergehenden Ansprüche, dadurch gekennzeichnet, daß der Halbleiterkörper (6) als Impattdiode ausgebildet wird.

4. Verfahren zur Herstellung eines beidseitig kontaktierten Halbleiterkörpers nach einem der vorhergehenden Ansprüche, dadurch gekennzeichnet, daß die Metallschutzschicht (5) das Element Chrom enthält.

5. Verfahren zur Herstellung eines beidseitig kontaktierten Halbleiterkörpers nach einem der vorhergehenden Ansprüche, dadurch gekennzeichnet, daß die Trennschicht (2b) aus dem Element Silber besteht.

6. Verfahren zur Herstellung eines beidseitig kontaktierten Halbleiterkörpers nach einem der vorhergehenden Ansprüche, dadurch gekennzeichnet,
— daß der von dem Trägerkörper abgelöste Halbleiterkörper (6) in ein Gehäuse eingebaut wird, das eine Wärmesenke aus Diamant enthält, und
— daß zwischen dem Halbleiterkörper (6) und dem Diamant ein guter Wärmekontakt erzeugt wird.

7. Verfahren zur Herstellung eines beidseitig kontaktierten Halbleiterkörpers nach Anpruch 6, dadurch gekennzeichnet, daß der Wärmekontakt durch Bonden hergestellt wird.

**Claims**

1. Method for the manufacture of a semiconductor body, which is provided with contacts at both sides, on a semiconductor layer (3), which is arranged on a carrier body (1), with a layer sequence corresponding to a semiconductor component,
- wherein the semiconductor layer (3) is bounded by an upper metallising layer (4) and a lower metallising layer (2),
- wherein a protective metal layer (5) is precipitated on the upper metallising layer (4) and
- wherein a further region (8) is formed in the protective metal layer (5), characterised thereby,
- that a semiconductor body (6) is produced out of the semiconductor layer (3) by underetching the further region (8),
- that the lower metallising layer (2) is removed, except for a region (7), photolithographically with the use of the further region (8) as mask,
- that a contact window (10), the area of which corresponds substantially to that of the semiconductor body (6), is produced in he further region (8),
- that at least one contact tape (11) is precipitated, which is connected by way of the contact window (10) with the semiconductor body (6), and
- that the carrier body (1) is removed subsequently.

2. Method according to claim 1, characterised thereby, that the lower metallising layer (2) contains a separating layer (2b) and that the separating layer (2b) is etched away for the removal of the carrier body.

3. Method for the manufacture of a semiconductor body, which is provided with contacts at both sides, according to one of the preceding claims, characterised thereby, that the semiconductor body (6) is constructed as Impatt diode.

4. Method for the manufacture of a semiconductor body, which is provided with contacts at both sides, according to one of the preceding claims, characterised thereby, that the protective metal layer (5) contains the element chromium.

5. Method for the manufacture of a semiconductor body, which is provided with contacts at both sides, according to one of the preceding claims, characterised thereby, that the separating layer (2b) consists of the element silver.

6. Method for the manufacture of a semiconductor body, which is provided with contacts at both sides, according to one of the preceding claims, characterised thereby,
- that the semiconductor body (6) released from the carrier body is built into a housing which contains a heat sink of diamond and
- that a good thermal contact is produced between the semiconductor body (6) and the diamond.

7. Method for the manufacture of a semiconductor body, which is provided with contacts at both sides, according to claim 6, characterised thereby, that the thermal contact is produced by bonding.

## Revendications

1. Procédé pour fabriquer un corps semi-conducteur pourvu de contacts des deux côtés, à partir d'une couche semi-conductrice (3) disposée sur un support (1) et comportant une succession de couches correspondant à un composant à semi-conducteur, procédé dans lequel
- on délimite la couche semi-conductrice (3) par une couche métallisée supérieure (4) et une couche métallisée inférieure (2),
- on dépose une couche métallique de protection (5) sur la couche métallisée supérieure (4) et
- on forme dans la couche métallique de protection (5) une zone résiduelle (8), caractérisé en ce que
- par gravure sous-jacente de la région résiduelle (8), on forme un corps semi-conducteur (6) à partir de la couche semiconductrice (3),
- en utilisant la zone residuelle (8) comme masque, on enlève, par voie photolythographique, la couche métallisée inférieure (2), à l'exception d'une région (7),
- on ouvre dans la zone résiduelle (8) une fenêtre de contact (10) dont l'aire de surface correspond pour l'essentiel à celle du corps semi-conducteur (6),
- on dépose au moins une bande de contact (11), laquelle est reliée à travers la fenêtre de contact (10) au corps semiconducteur (6), et

- on enlève ensuite le support (1).

2. Procédé selon la revendication 1, caractérisé en ce que la couche métallisée inférieure (2) contient une couche de séparation (2b) et que, pour enlever le support, on élimine la couche de séparation (2b) par gravure.

3. Procédé pour fabriquer un corps semi-conducteur pourvu de contacts des deux côtés, selon l'une des revendications précédentes, caractérisé en ce que le corps semi-conducteur (6) est réalisé pour constituer une diode à avalanche à temps de propagation.

4. Procédé pour fabriquer un corps semi-conducteur pourvu de contacts des deux côtés, selon l'une des revendications précédentes, caractérisé en ce que la couche métallique de protection (5) contient l'élément chrome.

5. Procédé pour fabriquer un corps semi-conducteur pourvu de contacts des deux côtés, selon l'une des revendications précédentes, caractérisé en ce que la couche de séparation (2b) est formée de l'élément argent.

6. Procédé pour fabriquer un corps semi-conducteur pourvu de contacts des deux côtés, selon l'une des revendications précédentes, caractérisé en ce que
- on monte le corps semi-conducteur (6), détaché du support, dans un boîtier qui contient un dissipateur thermique en diamant et
- on établit un bon contact thermique entre le corps semi-conducteur (6) et le diamant.

7. Procédé pour fabriquer un corps semi-conducteur pourvu de contacts des deux côtés, selon la revendication 6, caractérisé en ce que l'on réalise le contact thermique par "bonding".

FIG. 1a

FIG. 1b

FIG. 2

FIG. 3

FIG. 4

FIG. 5

FIG. 6

FIG. 7

FIG. 8

FIG. 9